# EUROPÄISCHE PATENTSCHRIFT

(11) **EP 3 087 306 B1**
(45) Veröffentlichungstag und Bekanntmachung des Hinweises auf die Patenterteilung: **04.10.2017**
(21) Anmeldenummer: 14796436.5
(22) Anmeldetag: 16.10.2014
(51) Int. Cl.: F21K 9/27, F21V 19/00, F21V 29/70, F21Y 103/00, F21Y 115/10

(54) **LEUCHTEINHEIT**
LIGHTING UNIT
UNITÉ D'ÉCLAIRAGE

(30) Priorität: 17.10.2013 DE 102013221141
(43) Veröffentlichungstag der Anmeldung: 02.11.2016
(73) Patentinhaber: Streibl, Annerose, 75438 Knittlingen (DE)
(72) Erfinder: Streibl, Annerose, 75438 Knittlingen (DE)
(74) Vertreter: Gleiss, Alf-Olav
(86) Internationale Anmeldenummer: PCT/EP2014/072273
(87) Internationale Veröffentlichungsnummer: WO 2015/055792

(56) Entgegenhaltungen:
- EP-A1- 2 354 629
- US-A1- 2013 199 768

## Beschreibung

Die Erfindung betrifft eine Leuchteinheit gemäß Oberbegriff des Anspruchs 1.

Leuchteinheiten der hier angesprochenen Art sind bekannt (EP 2 354 629 A1, US 2013/0199768 A1). Sie zeichnen sich durch einen komplexen Aufbau aus, der dazu führt, dass die Leuchteinheit relativ schwer ist und sich im Übrigen durch eine kostenintensive Herstellung auszeichnet.

Aufgabe der Erfindung ist es daher eine Leuchteinheit der hier angesprochenen Art zu schaffen, welche diese Nachteile vermeidet.

Zur Lösung dieser Aufgabe wird eine Leuchteinheit mit den Merkmalen des Anspruchs 1 vorgeschlagen, die sich durch einen einfachen, kostengünstig realisierbaren Aufbau auszeichnet. Sie weist eine Trägereinrichtung auf, welche sich aus vorzugsweise plattenförmigen Elementen, nämlich aus mindestens einem Basiselement und wenigstens zwei Zusatzelementen zusammensetzt. Die Basis- und Zusatzelemente sind zusammensteckbar, sodass auf übliche Verbindungsmittel verzichtet werden kann. Das mindestens eine Basiselement und die wenigstens zwei Zusatzelemente bilden einen der Aufnahme einer Platine dienenden Aufnahmebereich, in dem die Platine lagefixiert ist.

Besonders bevorzugt wird ein Ausführungsbeispiel der Leuchteinheit, das sich dadurch auszeichnet, dass wenigstens ein Kühlelement vorgesehen ist. Dieses ist mit der Platine so gekoppelt, dass durch das auf der Platine positionierte Leuchtelement entwickelte Wärme und/oder die Wärme zusätzlicher Bauteile effektiv abgeleitet werden kann.

Weitere Ausgestaltungen ergeben sich aus den Unteransprüchen.

Die Erfindung wird im Folgenden anhand der Zeichnungen näher erläutert. Es zeigen:
- Figur 1: eine Explosionsdarstellung eines ersten Ausführungsbeispiels einer Leuchteinheit;
- Figur 2: ein erstes Teilelement einer Trägereinrichtung, nämlich ein Basiselement;
- Figur 3;: ein Zusatzelement der Trägereinrichtung;
- Figur 4: eine Platine der Leuchteinheit in Draufsicht;
- Figur 5: eine Explosionsdarstellung der in Figur 1 wiedergegebenen Leuchteinheit in einem ersten Zusammenbauzustand;
- Figur 6: eine Explosionsdarstellung der in Figur 1 wiedergegebenen Leuchteinheit in einem zweiten Zusammenbauzustand;
- Figur 7: eine Explosionsdarstellung der in Figur 1 wiedergegebenen Leuchteinheit in einem dritten Zusammenbauzustand;
- Figur 8: eine Explosionsdarstellung der in Figur 1 wiedergegebenen Leuchteinheit in einer vierten Zusammenbauzustand;
- Figur 9: eine Explosionsdarstellung der in Figur 1 wiedergegebenen Leuchteinheit in einem fünften Zusammenbauzustand;
- Figur 10: eine perspektivische Unteransicht der zusammengebauten Leuchteinheit;
- Figur 11: eine vergrößerte perspektivische Detailansicht eines Endes der Leuchteinheit mit einem Anschlusselement in Explosionsdarstellung;
- Figur 12: eine perspektivische Ansicht des in Figur 11 wiedergegebenen Endes der Leuchteinheit mit einem montierten Anschlusselement;
- Figur 13: eine perspektivische Ansicht eines abgewandelten Basiselements der Trägereinrichtung.

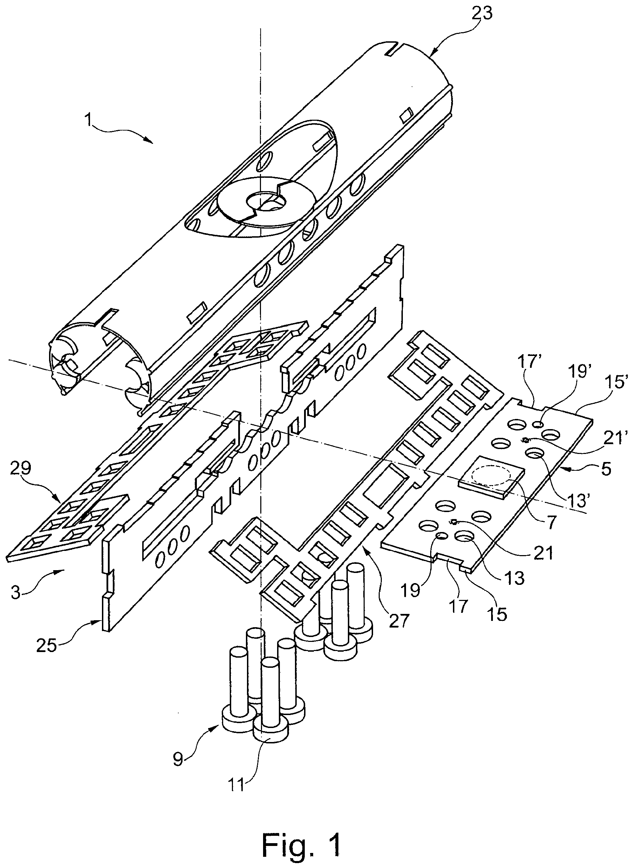

Figur 1 zeigt in Explosionsdarstellung eine Leuchteinheit 1 mit einer Trägereinrichtung 3 und einer Platine 5, die dazu dient, ein Leuchtelement 7, insbesondere eine lichtimitierende Diode (LED) auf ihrer Oberseite aufzunehmen. Dies ist in der Figur durch einen gestrichelten Kreis angedeutet. Die Art des Leuchtelements 7 ist grundsätzlich nicht von entscheidender Bedeutung, es können beliebige Leuchtmittel eingesetzt werden, jedoch werden Leuchtelemente mit mindestens einer LED bevorzugt. Die Platine 5 ist mit hier nicht dargestellten Leitungen zur elektrischen Versorgung des Leuchtelements 7 und gegebenenfalls mit zusätzlichen elektrischen beziehungsweise elektronischen Bauteilen versehen, die zum Betrieb des Leuchtelements 7 nötig beziehungsweise bevorzugt vorgesehen sind.

Die Leuchteinheit 1 ist vorzugsweise mit einer Kühleinrichtung 9 versehen, die mindestens ein Kühlelement 11 aufweist, die in zusammengebautem Zustand der Leuchteinheit 1 Wärme von wärmeproduzierenden Elementen der Leuchteinheit 1 abführen, beispielsweise von dem Leuchtelement 7 und/oder von mit dem Leuchtelement 7 zusammenwirkenden elektrischen beziehungsweise elektronischen Bauteilen, die vorzugsweise auf der Platine 5 angeordnet sind. Das mindestens eine Kühlelement 11 weist vorzugsweise wärmeleitfähiges Material auf oder besteht aus diesem. Es kann insbesondere stiftförmig ausgebildet sein, damit es die Leuchteinheit 1 durchdringen und die im Inneren derselben anfallende Wärme ableiten kann. Besonderes bevorzugt werden Schrauben als Kühlelemente 11 eingesetzt, die hier vorzugsweise in die Platine 5 eingreifen. Diese ist hier mit Löchern 13 versehen, die seitlich neben dem Leuchtelement 7 angeordnet sind. Hier sind jeweils vier Kühlelemente 11 neben dem Leuchtelement 7 vorgesehen. Insbesondere werden die Kühlelemente 11 bevorzugt in die Platine 5 eingeschraubt, die in diesem Fall mit einem Innengewinde versehene Löcher 13 aufweist.

Die Platine 5 ist als plattenförmiges Element ausgebildet und besteht aus einem Material, wie es für elektrische und elektronische Bauteile aufnehmende Platinen üblich ist, vorzugsweise aus mit Epoxidharz getränktem (Glas-)Fasermaterial. Bevorzugt können hier Metallkern-Platinen eigesetzt werden, insbesondere dann, wenn größere Wärmemengen von dem Leuchtelement 7 und den zugehörigen elektrischen beziehungsweise elektronischen Bauteilen abzuleiten sind.

Die Platine 5 ist hier bei dem wiedergegebenen Ausführungsbeispiel im Wesentlichen rechteckförmig ausgebildet und weist an ihren gegenüberliegenden Stirnseiten 15, 15' zu einer gedachten Längsmittellinie seitlich versetzte Ausschnitte 17, 17' auf, die punktsymmetrisch angeordnet und ausgebildet sind. Vorzugsweise werden mehrere Kühlelemente 11 eingesetzt, die in eine entsprechende Anzahl von Löchern 13 in die Platine 5 eingreifen. Hier sind jeweils vier Löcher in den Bereichen nahe der Stirnseiten 15, 15' der Platine 5 vorgesehen, die ebenfalls vorzugsweise punktsymmetrisch angeordnet sind.

Nahe der Stirnseiten 15, 15' sind mittig, das heißt auf einer gedachten Längsachse angeordnete Ausnehmungen 19, 19' vorgesehen, wobei in der Nähe jeder der Stirnseiten 15, 15' je eine Ausnehmung 19, 19' vorgesehen ist.

Die Platine 5 weist zusätzlich mindestens zwei Kontaktierungsflächen 21, 21' auf, die mit dem Leuchtelement 7 und zugehörigen Bauteilen elektrisch verbindbar sind. Auf die Darstellung von elektrischen Leitungen wurde hier allerdings verzichtet. Bei dem hier dargestellten Ausführungsbespiel sind beispielhaft die Kontaktierungsflächen 21, 21' Flächen jeweils in der Mitte zwischen vier Löchern 13 angeordnet, in welche im zusammengebauten Zustand der Leuchteinheit 1 Kühlelemente 11 eingreifen.

Die Leuchteinheit 1 kann vorzugsweise mit einem Gehäuse 23 versehen werden, welches in zusammengebautem Zustand der Leuchteinheit 1 die einzelnen Teile der Leuchteinheit 1 umgreift und schützend abdeckt. Es dient hier außerdem der Stabilisierung der Leuchteinheit 1, sodass dieses verwindungssteif und so stabil ausgebildet ist, dass ein Verbiegen der Leuchteinheit 1 verhindert wird. Das Gehäuse 23 ist insbesondere auch Längsstabil, sodass es möglich ist, die Leuchteinheit 1 in eine röhrenförmige Hülle, beispielsweise in ein Glasrohr einzuschieben, welches besonders bevorzugt so ausgebildet und dimensioniert ist, wie das Glas einer Leuchtstoffröhre.

Die Trägereinrichtung 3 besteht hier aus einer Anzahl von plattenförmigen Elementen, die in ineinandersteckbar sind, um die Trägereinrichtung 3 zu realisieren.

Eine besonders bevorzugte Leuchteinheit 1 zeichnet sich dadurch aus, dass die Trägereinrichtung 3 drei derartiger Elemente aufweist, nämlich ein Basiselement 25, welches innerhalb der Leuchteinheit 1 im Wesentlichen senkrecht steht und in welches X-förmig zwei Zusatzelemente 27 und 29 einsteckbar sind, und zwar dergestalt, dass sich Elemente, das Basiselement 25 und die Zusatzelemente 27 und 29 gegenseitig durchgreifen, wie unten näher erläutert werden wird.

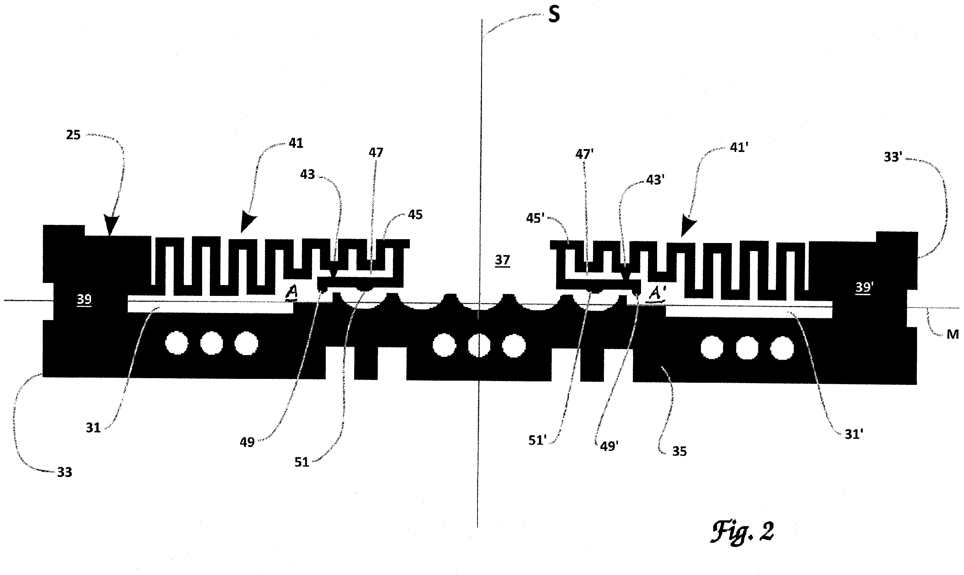

Figur 2 zeigt in seitlicher Ansicht das Basiselement 25 der in Figur 1 wiedergegebenen Trägereinrichtung 3. Es ist vorzugsweise symmetrisch zu der hier eingezeichneten Senkrechten S ausgebildet und weist rechts und links davon je einen Schlitz 31, 31' auf. Diese verlaufen entlang einer gedachten Mittellinie M des Basiselements 25, erstrecken sich jedoch nicht bis zu dem rechten und linken Ende 33, 33' des Basiselements 25. Die Schlitze 31, 31' dienen dazu, Wandbereiche der Zusatzelemente 27, 29 aufzunehmen, wenn diese Elemente in das Basiselement 2 seitlich eingeschoben werden. Darauf wird unten näher eingegangen.

Oberhalb der Schlitze 31, 31' sind Aufnahmebereiche A, A' für die Platine 5 vorgesehen, die sich oberhalb der der Senkrechten S zugewandten Enden der Schlitze 31, 31' in Richtung auf die Senkrechte S erstrecken.

Unterhalb der Mittellinie M erstreckt sich ein durchgehender Wandbereich 35. Der oberhalb dieser Mittellinie M verlaufende Wandbereich des Basiselements 25 ist im Bereich der Senkrechten S unterbrochen, sodass hier eine Längsausnehmung 37 gebildet wird.

Von einem die Mittellinie M überspannenden Wandbereich 39 am Ende 33 des Basiselements 25 erstreckt sich oberhalb des Schlitzes 31 ein Arm 41 bis zur Längsausnehmung 37. Entsprechend erstreckt sich von einem die Mittellinie M überspannenden Wandbereich 39' am Ende 33' des Basiselements 25 ein Arm 41' bis zur Längsausnehmung 37. Von den Armen 41 und 41' geht jeweils ein Kontaktarm 43, 43' aus, der vorzugsweise federnd mit dem Arm 41, 41' verbunden ist.

Vorzugsweise ist auch zumindest einer der Arme 41, 41', vorzugsweise beide in sich federnd ausgebildet. Die Federeigenschaften können dadurch realisiert werden, dass die Arme 41 und 41' zumindest abschnittsweise im Bereich zwischen dem Wandbereich 39, 39' und der Längsausnehmung 37 elastisch vorzugsweise mäanderförmig ausgebildet sind. Vorzugsweise sind die Arme 41, 41', wie in Figur dargestellt, über ihre gesamte Länge mäanderförmig ausgebildet. Die Kontaktarme 43, 43' gehen vorzugsweise von den der Längsausnehmung 37 zugewandten Enden 45, 45' der Arme 41, 41' aus. Von den Enden 45, 45' verlaufen die Kontaktarme 43, 43' zurück in Richtung der zugehörigen Wandbereiche 39, 39', wobei zwischen den Armen 41, 41' und den Kontaktarmen 43, 43' jeweils ein Schlitz 47, 47' ausgebildet ist, sodass die Kontaktarme 43, 43' - hier von der Mittellinie M aus gesehen - nach oben ausweichen können.

Die Kontaktarme 43, 43' haben an ihren freien Enden eine sich in Richtung der Mittellinie M erstreckende Nase 49, 49' und in einem Abstand dazu einen leitenden Bereich, der als Kontaktbereich 51, 51' dient, auf den unten näher eingegangen wird. Der Kontaktbereich 51, 51' kann durch Kantenmetallisierung realisiert werden.

Das Basiselement 25 ist vorzugsweise deshalb symmetrisch zur Senkrechten S ausgebildet, dass es beim Zusammenbau der Trägereinrichtung 3 universell verwendbar ist: Es kann mit den Zusatzelementen 27, 29 bestückt werden, wobei es möglich ist, dass Basiselement 25 um die Senkrechte S um 180° zu verdrehen und dann mit den Zusatzelementen 27, 29 zu bestücken. Dies erleichtert die Montage des Trägerelements 3.

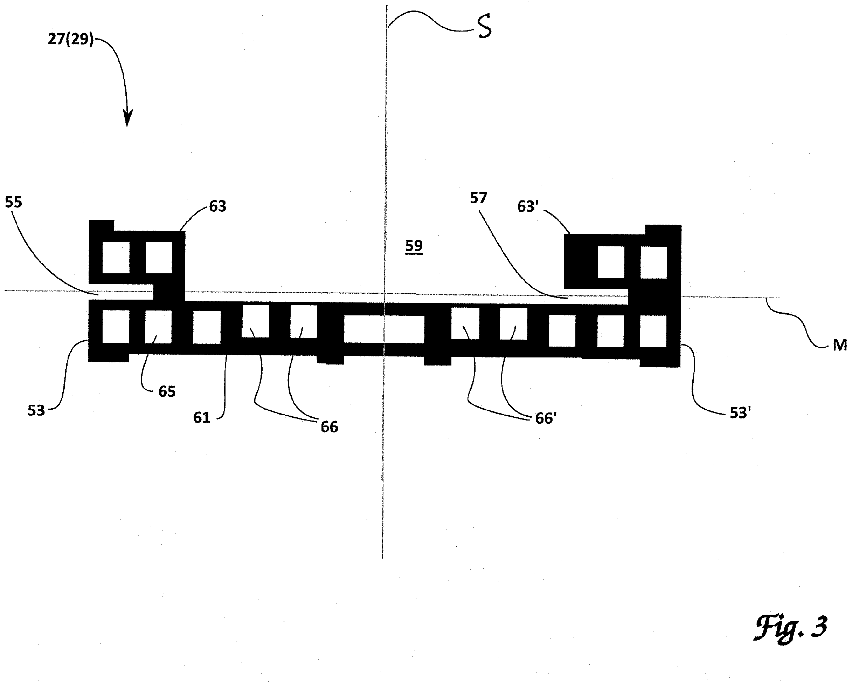

Figur 3 zeigt ein Zusatzelement 27 der in Figur 1 dargestellten Trägereinrichtung 3 es sei hier bereits darauf hingewiesen, dass das Zusatzelement 27 vorzugsweise identisch ausgebildet ist, wie das in Figur 1 dargestellte Zusatzelement 29. Dies führt zu einer preiswerten Herstellung der Trägereinrichtung 3, weil es eben möglich ist, identisch ausgebildete Zusatzelemente 27 und 29 bei dem Aufbau der Trägereinrichtung 3 zu verwenden.

Vorzugsweise ist vorgesehen, dass die Grundstruktur des Zusatzelements 27, damit auch die des Zusatzelements 29, symmetrisch ist zu der hier eingezeichneten Senkrechten S. Es weist einen zum linken Ende 53 des Zusatzelements 27 offenen Schlitz 55 auf, der sich entlang der Mittellinie M erstreckt.

Das rechte Ende 53' ist geschlossen, das heißt, es weist keinen sich in Richtung dieses Endes 53' öffnenden Schlitz auf. Vielmehr ist hier ein entlang der Mittellinie M verlaufender Schlitz 57 vorgesehen ist, der sich hier nach links in Richtung auf die Senkrechte S öffnet, also von dem Ende 53' weg gerichtet ist. Bezüglich dieser Schlitze 55, 57 ergibt sich also eine Abweichung von der grundsätzlichen Symmetrie des Zusatzelements 27.

Rechts und links von der Senkrechten S ist jeweils ein Freiraum vorgesehen, sodass auch hier bei dem Zusatzelement 27 eine Längsausnehmung 59 geschaffen wird, die vorzugsweise symmetrisch zur Senkrechten S ausgebildet ist.

Unterhalb der Mittellinie M weist das Zusatzelement 27 einen durchgehenden Wandabschnitt 61 auf, während oberhalb der Mittellinie M am linken und rechten Ende 53, 53' jeweils ein Wandbereich 63 beziehungsweise 63' vorhanden ist, wobei diese Wandbereiche 63, 63' die Längsausnehmung 59 rechts und links begrenzen. In diesen Wandbereichen 63, 63' sind die Schlitze 55 und 57 vorgesehen, die im Übrigen symmetrisch zur Mittellinie M verlaufen.

Es sei hier nochmal darauf hingewiesen, dass das Zusatzelement 27 und das Zusatzelement 29 identisch ausgebildet sind. Es wird sich zeigen, dass das Zusatzelement 27 in der in Figur 3 wiedergebebenen Position in das Basiselement 25 eingesteckt wird, um die Trägereinrichtung 3 zu realisieren, während das Zusatzelement 29 um die Senkrechte S um 180° verdreht wird, wenn es in das Basiselement 25 eingesteckt wird. Darauf wird unten näher eingegangen.

Zur Gewichtsverminderung ist vorzugsweise vorgesehen, dass die Zusatzelemente 27, 29, die wie das Basiselement 25 plattenförmig ausgebildet sind, eine Anzahl von Materialaussparungen 65 aufweisen können, deren Größe und Anzahl wird angepasst an die Stabilität des Material Zusatzelemente 27 und 29. Vorzugsweise wird hier, wie auch bei dem Basiselement 25 ein Kunststoffmaterial eingesetzt, dass gegebenenfalls faserverstärkt werden kann. Auch glasfaserverstärkte Materialien können zur Realisierung der Trägereinrichtung 3 eingesetzt werden. Grundsätzlich weisen die Zusatzelemente 27 und 29 unabhängig von den Materialaussparungen 65 - vorzugsweise rechts und links von der Senkrechten S - mindestens eine Durchbrechung 66 und 66' auf, hier je zwei Durchbrechungen 66 und 66', durch welche das mindestens eine Kühlelement 11 im zusammengebauten Zustand der Leuchteinheit 1 hindurchgreift. Darauf wird unten noch näher eingegangen.

Das Basiselement 25 und die Zusatzelemente 27 und 29 sind vorzugsweise rechteckförmig ausgebildet.

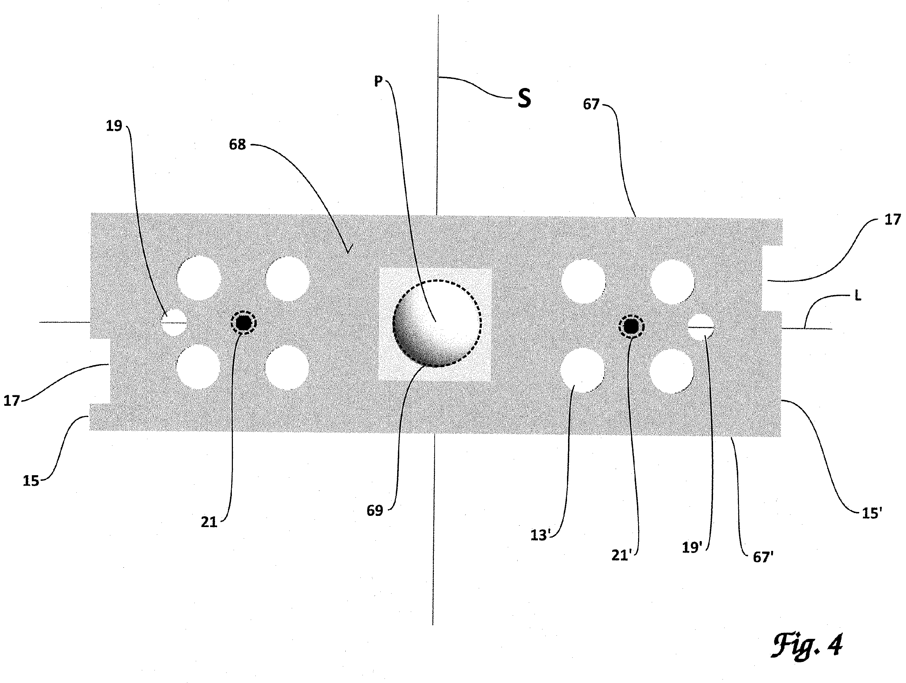

Figur 4 zeigt in Draufsicht die Platine 5 der in Figur 1 dargestellten Leuchteinheit 1. Auch die Platine 5 ist vorzugsweise rechteckförmig und insbesondere plattenförmig ausgebildet. Sie ist punktsymmetrisch zu einem auf der Längsmittellinie L liegenden Mittelpunkt P ausgelegt.

Auch hier sind die an den gegenüberliegenden Stirnseiten 15, 15' vorgesehenen Ausnehmungen 17, 17' zu erkennen, die hier als langgestreckte Nut ausgebildet sind, welche zwischen den Längsseiten 67 und 67' und der Längsmittellinie L in den Stirnseiten 15, 15' verlaufen.

Deutlich erkennbar sind hier die auf der Längsmittellinie L angeordneten Ausnehmungen 19, 19' und die Kontaktflächen 21 und 21', die durch eine Metallisierung des Grundmaterials der Platine 5 realisierbar sind.

Rechts und links einer Senkrechten S, die durch den an der Längsmittelinie L liegenden Mittelpunkt P der Platine 5 verläuft, sind in einem Abstand dazu jeweils vier Löcher 13 vorgesehen, die hier beispielhaft an den Ecken eines gedachten Quadrats angeordnet sind, sodass zwischen den Löchern 13 und der Senkrechten S ein Bereich verbleibt, in den ein Leuchtelement und zugehörigen elektrische und elektronische Bauteile auf der Platine 5 realisierbar sind. Hier sind auf der Oberseite 68 der Platine 5 mehrere durch Quadrate und Rechtecke angedeutete Bereiche vorgesehen, in denen elektrischen und elektronische Bauteile angeordnet und angeschlossen werden können. Zentral ist ein größerer Bereich 69 vorgesehen, in dem das Leuchtelement anordenbar ist, das vorzugsweise eine oder mehrerer LED umfasst, die hier nicht dargestellt sind.

Dadurch, dass die Platine 5 punktsymmetrisch ausgebildet ist, kann die Platine 5, wie in Figur 4 dargestellt, beim Zusammenbau der Leuchteinheit 1 verwendet werden, oder aber um 180° verdreht, wobei die Verdrehung um eine senkrecht auf der Oberseite 68 verlaufende gedachte Linie verläuft, die den Schnittpunkt zwischen der Längsmittellinie L und der Senkrechten S, also den Mittelpunkt P, schneidet.

Die Platine 5 ist vorzugsweise so mit einem Leuchtelement und einer elektrischen beziehungsweise elektronischen Beschaltung und mit Leiterbahnen versehen, dass die Verdrehung der Platine um die gedachte Drehachse für die Funktion des Leuchtelements keine Rolle spielt.

Beim Zusammenbau der Leuchteinheit 1 greift jeweils eine Nase 49, 49' der Kontaktarme 43, 43' in die Ausnehmung 19, 19' ein, sodass die Platine 5 sicher in der Leuchteinheit 1 beziehungsweise an der Trägereinrichtung 3 gehalten wird. Außerdem werden dadurch die Kontaktarme 43, 43' sowie die Arme 41, 41' stabilisiert. Zudem wird durch die Ausnehmungen 19, 19' sichergestellt, dass bei einem korrekten Eingriff der Nasen 49, 49' die elektrisch leitenden Bereiche, nämlich die Kontaktbereiche 51, 51' der Kontaktarme 43, 43' elektrisch leitend an den Kontaktierungsflächen 21, 21' anliegen.

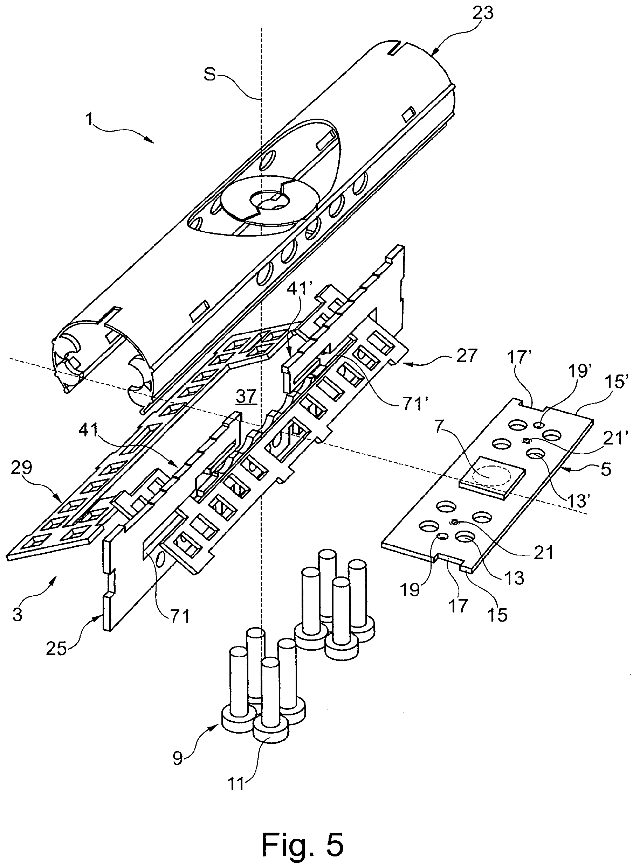

Figur 5 zeigt die Leuchteinheit in Explosionsdarstellung ähnlich wie in Figur 1 in einem ersten Zusammenbauzustand. Gleiche Teile sind mit gleichen Bezugsziffern versehen, sodass auf die vorangegangene Beschreibung verwiesen wird.

Vergleicht man die Darstellungen der Figuren 1 und 5, so zeigt sich, dass in Figur 5 das erste Zusatzelement 27 unter einem Winkel von vorzugsweise 45° in die Schlitze 31 und 31' des Basiselements 25 eingeschoben ist. Bei diesem ersten Zusammenbauzustand ist der Wandbereich 63 des Zusatzelements 27 in den Schlitz 31 und der Wandbereich 63' in den Schlitz 31' im Basiselement 25 eingesteckt. Dabei ist vorgesehen, dass das Zusatzelement 27', in axialer Richtung des Basiselements 25 gesehen, - in der perspektivischen Darstellung - nach rechts oben verlagert wird, während die Wandbereiche 63 und 63' in die Schlitze 31 und 31' des Basiselements 25 eingesteckt werden. Dabei liegt also das rechte Ende 53' des Zusatzelements 27 nahe dem dem rechten Ende 33' zugewandten Ende des Schlitzes 31' im Basiselement 25.

Das in das Basiselement 25 eingesteckte Zusatzelement 27 ist so angeordnet, wie dies in Figur 3 dargestellt ist. Der Schlitz 55 ist also in Figur 5 nach links unten gerichtet und wirkt mit dem Schlitz 31 im Basiselement 25 so zusammen, dass ein Freiraum 71 verbleibt, in den der Wandbereich 63' des Zusatzelements 29 eingeschoben werden kann, worauf unten näher eingegangen wird. Entsprechend bleibt rechts von der Längsausnehmung 59 ein Freiraum 71', in welchen der Wandbereich 63 des Zusatzelements 29 eingeschoben werden kann.

In dem ersten Zusammenbauzustand gemäß Figur 5 ist allerdings lediglich das Zusatzelement 27 in das Basiselement 25 eingeschoben, wobei die Wandbereiche 63 und 63' des Zusatzelements 27 in die Schlitze 31 und 31' eingreifen.

Aus Figur 5 ist erkennbar, dass das Zusatzelement 27, wie gesagt, in der perspektivischen Darstellung nach rechts oben verlagert ist, während das Zusatzelement 29 in Längsrichtung des Basiselements 25 versetzt links unten angeordnet ist.

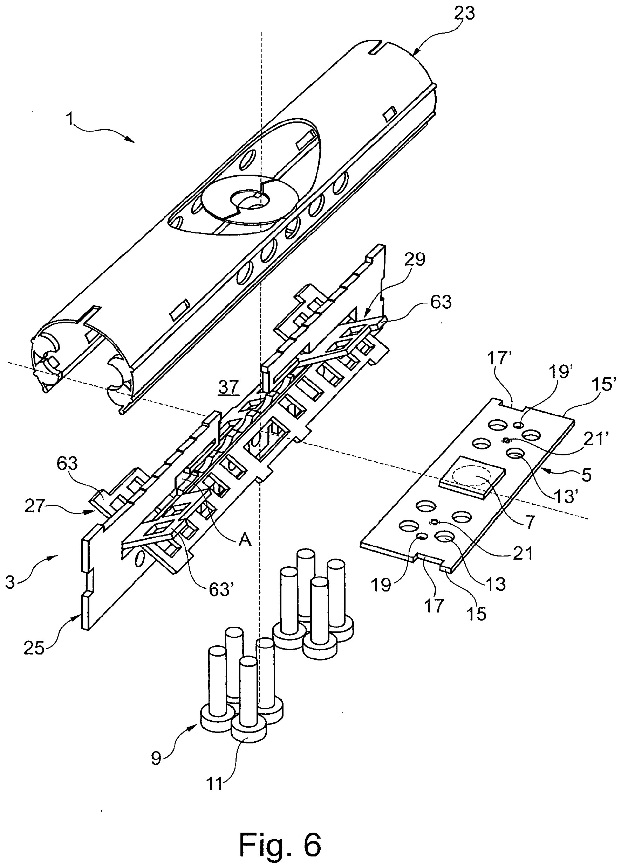

Figur 6 zeigt die Leuchteinheit 1 in einem zweiten Zusammenbauzustand, in welchem nun auch das Zusatzelement 29 unter einem Winkel von vorzugsweise 45° in das Basiselement 25 eingeschoben ist. Das Zusatzelement 29 ist dabei entgegengesetzt zum Zusatzelement 27 geneigt. Während der durchgehende Wandbereich 61 des Zusatzelements 27 gegenüber einer gedachten Horizontalen nach rechts unten verschwenkt ist, ist der durchgehende Wandbereich 61 des Zusatzelements 29 gegenüber der gedachten Horizontalen nach links unten verkippt. Darüber hinaus ist das Zusatzelement 29 gegenüber der in Figur 3 dargestellten Position um die Senkrechte S um einen Winkel von 180° gedreht. Die Zusatzelemente 27 und 29 werden also in entgegengesetzter Orientierung in die Schlitze 31 und 31' in das Basiselement 25 eingesteckt.

In Figur 6 ist der Wandbereich 63' des Zusatzelements 29 in den in Figur 5 dargestellten Freiraum 71 im Basiselement 25 eingeschoben. Entsprechend ist der Wandbereich 63 des Zusatzelements 29 in den Freiraum 71' (siehe Figur 5) im Basiselement 25 eingeschoben. Das Zusatzelement 29 ist also gegenüber dem Zusatzelement 27 nach links unten - in Figur 6 - versetzt in das Basiselement 25, genauer in dessen Schlitze 31, 31' eingeschoben.

Die übrigen Bauteile der Leuchteinheit 1 sind in Figur 6 noch in Explosionsdarstellung wiedergegeben. In Figur 6 sind die beiden Zusatzelemente 27 und 29 mit Ihren Wandbereichen 63 und 63' in die Schlitze 31 und 31' des Basiselements 25 lediglich eingeschoben. Dabei werden die Zusatzelemente 27 senkrecht zu ihrer Längserstreckung, also senkrecht zu der in Figur 3 wiedergebebenen Mittellinie M verlagert, während das erste Zusatzelement 27 innerhalb der Schlitze 31 und 31' ganz nach rechts verschoben ist, während das zweite Zusatzelement 29 in den Schlitzen 31 und 31' ganz nach links verlagert ist.

Wenn die beiden Zusatzelemente 27 und 29 in das Basiselement 25 seitlich eingeschoben werden, liegen deren Wandbereiche 63 und 63' - in Längsrichtung des Basiselements 25 gesehen - nebeneinander in den Schlitzen 31 und 31'. Die Zusatzelemente 27 und 29 sind, wie aus Figur 3 ersichtlich, mit Schlitzen 55 und 57 versehen. In der in Figur 6 dargestellten Position greifen die Wandbereiche 63 und 63' der Zusatzelemente 27 und 29 jedoch nicht ineinander ein, sodass die Zusatzelemente 27 und 29 beziehungsweise deren Wandbereiche 63 und 63' frei seitlich in die Schlitze 31 und 31' des Basiselements 25 einsteckbar sind.

In Figur 6 ist also mit dem zweiten Zusammenbauzustand eine Fügeposition der beiden Zusatzelemente 27 und 29 im Basiselement 25 dargestellt. Das heißt, die Zusatzelemente 27 und 29 können, sofern die beim Einstecken gegebenen Reibungskräfte überwunden sind, aus dem Basiselement 25 wieder herausfallen.

Die Montage kann auch wegen der identischen Ausgestaltung der Zusatzelemente 27 und 29 so durchgeführt werden, dass zunächst das zweite Zusatzelement 29 und dann das erste Zusatzelement 27 in das Basiselement 25 eingeschoben wird.

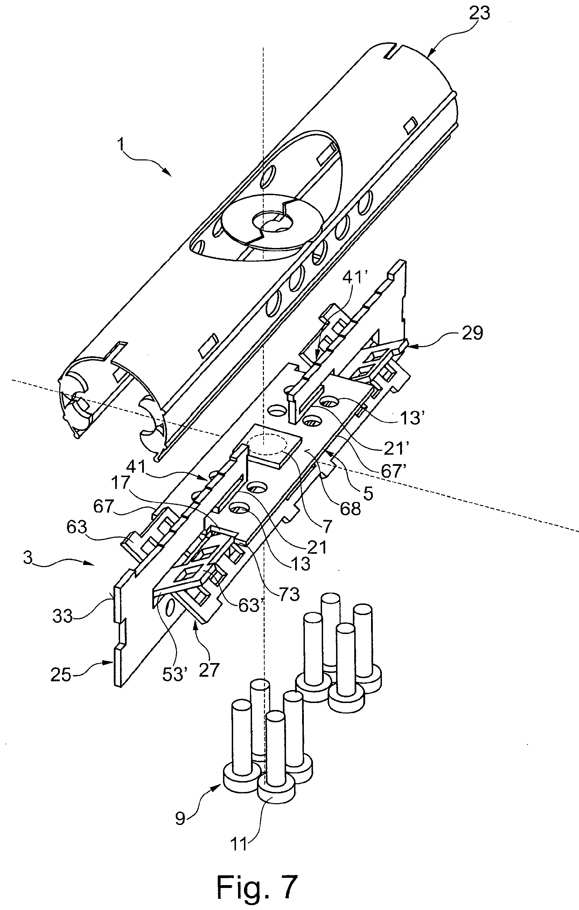

Figur 7 zeigt die Leuchteinheit 1 in einem dritten Zusammenbauzustand. Die beiden Zusatzelemente 27 und 29 sind wie in Figur 6 dargestellt, in das Basiselement 25 eingesteckt. Das Zusatzelement 29 liegt nach den Definitionen gemäß Figur 3 mit seinem rechten Ende 53' nahe dem dem Ende 33 des Basiselements 25 nächstliegenden Ende des Schlitzes 31. Es ist gemäß Figur 7 in einer nach links unten gegenüber dem Basiselement 25 versetzten Position angeordnet.

Das Zusatzelement 27 ist bei der Darstellung in Figur 7 aus der in Figur 6 dargestellten Position etwas nach links unten verschoben, sodass das Zusatzelement 29 mit seinem Wandbereich 63' in den Schlitz 55 im Zusatzelement 27 eingreift. Das Zusatzelement 27 wird so weit nach links unten gegenüber dem Zusatzelement 29 verlagert, bis dessen Wandbereich 63 den Aufnahmebereich A im Basiselement 25 freigibt.

In dieser Position kann, wie in Figur 7 dargestellt, die Platine 5 seitlich in die 'Aufnahmebereiche A, A' im Basiselement 25 eingeschoben werden, und zwar so weit, bis die Längsmittellinie L im Bereich der beiden Aufnahmebereiche A, A' liegt.

Durch die Teilverlagerung des Zusatzelements 27 gegenüber dem Zusatzelement 29 und dem Basiselement 25 greift das Zusatzelement 29 in das Zusatzelement 27 ein, sodass eine Haltestellung gegeben ist, in der die beiden Zusatzelemente 27 und 29 nicht mehr aus dem Basiselement 25 herausfallen können. Beim Einschieben der Platine 5 in die Längsausnehmung 27 beziehungsweise die 'Aufnahmebereiche A, A' im Basiselement 25 ist die in Figur 7 rechte Längsseite 67' etwas gegenüber einer horizontalen Ausrichtung, in welcher die Platine 5 und das Basiselement 25 senkrecht zueinander stehen, angehoben, sodass eine Nase 73 der Platine 5 oberhalb des Wandbereichs 63' des Zusatzelements 29 angeordnet ist. Wenn die Längsmittellinie L der Platine 5 innerhalb der Aufnahmebereiche A, A' angeordnet ist, kann diese in die Horizontale verschwenkt werden, wobei die Nase 73 abgesenkt wird und unterhalb des Wandbereichs 63' angeordnet ist. Der schrägstehende Wandbereich 63' des Zusatzelements 29 greift nun in die Ausnehmung 17 der Platine 5 ein.

Bei der Erläuterung zu Figur 7 wurde davon ausgegangen, dass die beiden Zusatzelemente 27 und 29 aus der in Figur 6 dargestellten Fügeposition, in welcher die Wandbereiche 63 und 63' der Zusatzelemente 27, 29 nebeneinander in den Schlitzen 31, 31' liegen, in eine Position verbracht werden, in der die Wandbereiche 63 und 63' eines Zusatzelements 27 in die Wandbereiche 63 und 63' des anderen Zusatzelements 29 eingreifen. Dabei wurde in den Erläuterungen oben davon ausgegangen, dass das Zusatzelement 27 gegenüber dem Zusatzelement 29 in axialer Richtung verlagert wird, nämlich nach unten links.

Denkbar ist es auch, dass aus der Fügeposition gemäß Figur 6 das Zusatzelement 29 gegenüber dem Zusatzelement 27 verlagert wird, wobei das Zusatzelement 29 nach oben rechts verschoben wird.

Schließlich ist es möglich, beide Zusatzelemente 27 und 29 aus der in Figur 6 wiedergegebenen Fügeposition, in Längsrichtung des Basiselements 25 gesehen, aufeinander zu zu bewegen, also das Zusatzelement 27 nach unten links und das Zusatzelement 29 nach oben rechts.

Entscheidend ist also, dass die Wandbereiche 63 und 63' der beiden Zusatzelemente 27 und 29 in der Fügeposition gemäß Figur 6 nebeneinander liegen und nicht ineinandergreifen, während sie in der Halteposition gemäß Figur 7 ineinandergreifen, sodass sie nicht mehr aus dem Basiselement 25 seitlich herausfallen können.

Um die Platine 5 seitlich in die Aufnahmebereich A und A' des Basiselements 25 einschieben zu können, müssen die Arme 41 und 41' angehoben werden. Dazu werden sie an ihren der Längsausnehmung 37 zugewandten Enden angehoben, sodass die Platine 5 frei in das Basiselement 25 eingeschoben werden kann.

Aufgrund ihrer Federeigenschaften bedarf es einer gewissen Kraft, um die Arme 41, 41' an ihren Enden gegen die Rückstellkraft auszulenken. Sobald die Enden der Arme 41, 41' freigegeben werden, federn diese zurück in Richtung auf die Oberseite 68 der Platine 5. Dabei greifen die hier nicht deutlich sichtbaren, anhand von Figur 2 erläuterten Nasen 49, 49' der Kontaktarme 43, 43' in die Ausnehmungen 19, 19' in der Platine 5 ein, und die Kontaktbereiche 51, 51' der Kontaktarme 43, 43' werden gegen die Kontaktflächen 21, 21' der Platine 5 gedrängt.

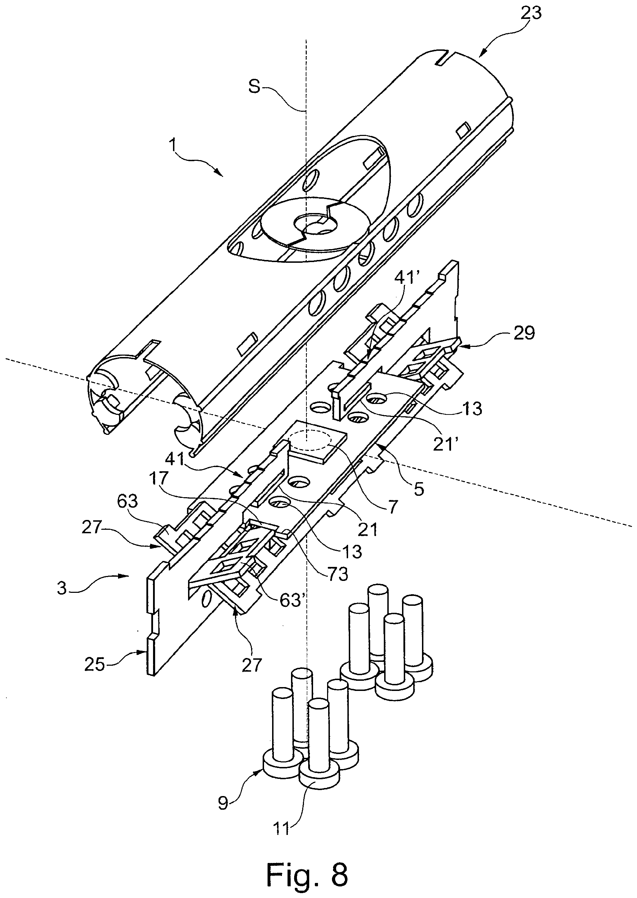

Figur 8 zeigt einen vierten Zusammenbauzustand der Leuchteinheit 1 in Explosionsdarstellung. Gleiche Teile sind mit gleichen Bezugsziffern versehen, sodass insofern auf die Beschreibung in den vorangegangenen Figuren verwiesen wird.

Vergleicht man die Figuren 7 und 8, so zeigt sich, dass das erste Zusatzelement 27 aus der in Figur 7 dargestellten Halteposition weiter gegenüber dem Zusatzelement 29 und dem Basiselement 25 verschoben wurde, bei der perspektivischen Darstellung gemäß Figur 8 nach links unten. Dadurch greift der rechts oben liegende Wandabschnitt 63' des Zusatzelements 27 in den Ausschnitt 17' in der Platine 5, sodass diese nun im Bereich beider Stirnseiten 15 und 15' durch die in die Ausschnitte 17 beziehungsweise 17' eingreifenden Wandabschnitte 63' beziehungsweise 63 der Zusatzelemente 27 und 29 in der Längsausnehmung 37 des Basiselements 25 sicher fixiert wird.

Figur 8 zeigt also eine Fixierposition der Zusatzelemente 27 und 29 innerhalb des Basiselements 25. Dabei ist vorzugsweise vorgesehen, dass nach dem Zusammenstecken der Zusatzelemente 27 und 29 mit dem Basiselement 25 das Zusatzelement 27 aus der Flügelposition gemäß Figur 6 über die Halteposition gemäß Figur 7 in die Fixierposition gemäß Figur 8 verlagert wird. Bezüglich der Verlagerung des Zusatzelements 27 gegenüber dem Zusatzelement 29 gilt das zu den Figuren 6 und 7 Gesagte entsprechend.

In der Halteposition ist sichergestellt, dass die Zusatzelemente 27 und 29 nicht aus dem Basiselement 25 herausfallen können. Außerdem ist gewährleistet, dass die Platine 5 sicher in der das Basiselement 25 und die Zusatzelemente 27 und 29 aufweisenden Trägereinrichtung 3 gehalten wird.

Während Figur 7 die Arme 41 und 41' in ihrer angehobenen Position darstellt sind, ist hier in Figur 8 erkennbar, dass die Arme 41, 41' losgelassen wurden und aufgrund ihrer Federeigenschaften in Richtung auf die Platine 5 zurückgefedert sind. Da sich die Platine 5 in den Aufnahmebereichen A und A' befindet, können die Arme 41 und 41' nicht so weit in die Position zurückfedern, die in Figur 2 dargestellt ist. Die zurückgefederten Arme 41, 41' drängen die Nasen 49, 49' in die Ausnehmungen 19, 19'. Nur wenn die Nasen mit den Ausnehmungen in eine Eingriffsposition gebracht sind, können die Arme 41 und 41' in die in Figur 8 dargestellte Position zurückfedern. Sollten sie also weiter nach oben als hier dargestellt ausgeschwenkt sein, ist dies ein Indiz dafür, dass die Platine 5 nicht korrekt in die Aufnahmebereiche A, A' eingesetzt ist und die Kontaktarme 43, 43' nicht korrekt in die Platine 5 eingreifen.

In der in Figur 8 dargestellten Position befindet sich die Platine 5 in ihrer korrekten Endlage, sodass die Arme 41, 41' maximal nach unten, das heißt in Richtung auf die Platine 5, zurückgefedert sind, und dass die Kontaktbereiche 51, 51' sicher mit den Kontaktflächen 21, 21' in Berührung stehen. Damit ist eine optimale Energieversorgung des Leuchtelements 7 und der gegebenenfalls vorhandenen elektrischen und elektronischen Bauelemente gewährleistet.

Sollte die Platine 5 ausgetauscht werden müssen, sei es wegen eines Defekts oder weil ein anderes Leuchtelement 7 zum Einsatz kommen soll, müssen die Arme 41, 41' aus der in Figur 8 dargestellten Position wieder nach oben verschwenkt werden, also weg von der Oberfläche 68 der Platine 5, sodass diese aus den Aufnahmebereichen A, A' herausgenommen werden kann. Dazu werden die Zusatzelemente 27 und 29 in Richtung ihrer Längsachsen auseinander geschoben, sodass sie aus der Fixierposition gemäß Figur 7 in ihre Halteposition gemäß Figur 6 gelangen. Dadurch wird die Platine 5 freigegeben.

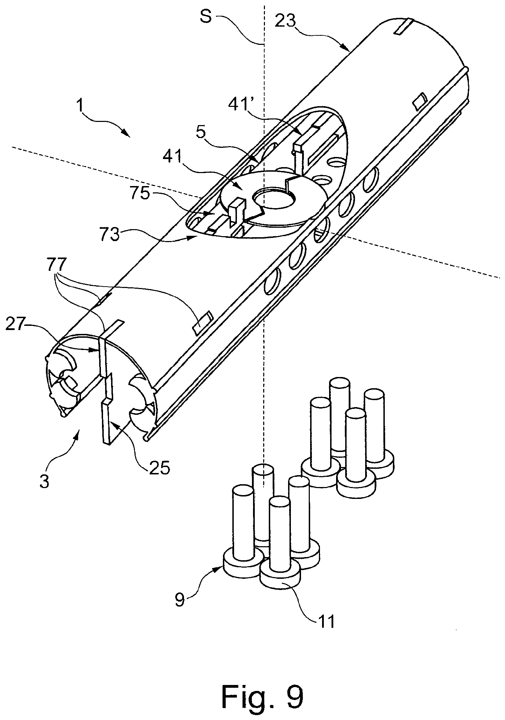

Figur 9 zeigt in Explosionsdarstellung einen fünften Zusammenbauzustand der Leuchteinheit 1. Gleiche Teile sind mit gleichen Bezugsziffern versehen, sodass insoweit auf die vorangegangene Beschreibung verwiesen wird.

Die Leuchteinheit 1 kann ohne ein Gehäuse 23 ausgebildet werden. Vorzugsweise wird jedoch, um eine Stabilisierung der Leuchteinheit zu gewährleisten und um das Leuchtelement und zugehörige Bauteile vor Beschädigungen zu schützen, ein Gehäuse 23 vorgesehen. Dies führt überdies dazu, dass elektrische Leitungen zur Versorgung des Leuchtelements und zugehöriger elektrischer und elektronischer Bauteile nicht ohne weiteres zugänglich sind, sodass Verletzungen von Nutzern der Leuchteinheit mit hoher Sicherheit vermieden werden können.

In Figur 9 ist dargestellt, dass die Trägereinrichtung 3 und die Platine 5 durch das Gehäuse 23 abdeckbar sind, welches die Trägereinrichtung 3 und die Platine 5 von außen übergreift.

Im mittleren Bereich des Gehäuses 23 ist hier ein Ausschnitt 73 vorgesehen, der sicherstellt, dass von der Leuchteinheit emittiertes Licht optimal und störungsfrei abgestrahlt wird. Zur Beeinflussung des abgestrahlten Licht können in den Ausschnitt 23 Elemente eingebracht werden, hier beispielsweise eine Ringblende 75, welche den mittleren Bereich der Platine 5 umgibt, in dem das Leuchtelement vorgesehen ist. Zusätzlich oder anstelle der Ringblende 75 können Farbeinsätze, Lamellen zur speziellen Ausrichtung abgestrahlten Lichts, Linsen oder dergleichen vorgesehen werden, die hier zur Vereinfachung der Darstellung nicht wiedergegeben sind.

Das Gehäuse 23 kann mehrteilig ausgebildet und von außen auf die Trägereinrichtung und auf die Platine 5 aufgesetzt werden. Vorzugsweise ist - wie dargestellt - vorgesehen, dass das Gehäuse 23 im wesentlichen rohrförmig ausgebildet ist und elastische Bereiche aufweist beziehungsweise aus einem elastischen Material besteht, derart, dass es aufgespreizt und auf die Trägereinrichtung 3 mit der Platine 5 aufgesetzt werden kann.

Das Gehäuse 23 ist unten offen. Es umgreift die Trägereinrichtung 3 und die Platine 5 und hält sich auf Grund der Eigenelastizität selbst.

Die Wandung des Gehäuses 3 kann vorzugsweise Aussparungen 77 aufweisen, in welche von innen Vorsprünge der Trägereinrichtung 3, insbesondere des Basiselements 25 und der Zusatzelemente 27 eingreifen, um das Gehäuse 23 noch sicherer zu halten.

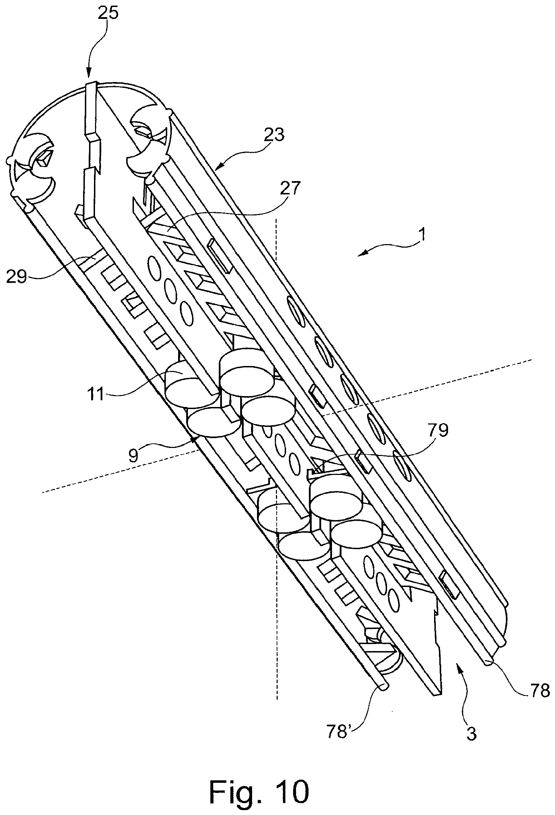

Figur 10 zeigt die Leuchteinheit 1 in zusammengebautem Zustand in perspektivischer Darstellung und zwar von schräg unten. Gleiche Teile sind mit gleichen Bezugsziffern versehen, sodass insofern auf die vorangegangene Beschreibung verwiesen wird.

Eine Veränderung gegenüber dem fünften Zusammenbauzustand gemäß Figur 9 besteht darin, dass das mindestens eine Kühlelement 11, hier acht Kühlelemente in die Leuchteinheit 1 eingebracht sind. Die Kühlelemente 11 sind vorzugsweise als Schrauben ausgebildet, welche die Leuchteinheit 1 von unten durchdringen und durch Durchbrechungen 66 in den Zusatzelementen 27,29 sowie durch die Löcher 13 in der Platine 5 ragen. Vorzugsweise sind wie oben gesagt, die Löcher 13 mit einem innenliegenden Gewinde versehen, welches mit einem Außengewinde der als Schrauben ausgebildeten Kühlelemente 11 zusammenwirkt. Die Länge der Schraube kann so gewählt werden, dass diese die Platine 5 durchgreifen und rechts und links von der Ringblende 75 in den Ausschnitt 73 im Gehäuse 23 ragen und insbesondere vorzugsweise dergestalt, dass eine gedachte rohrförmige Außenkontur des Gehäuses im Bereich des Ausschnitts 73 nicht durchstoßen wird. Dadurch ergeben sich oberhalb der Platine 5 Abschnitte der Kühlelemente 11, welche Wärme durch den Ausschnitt 73 im Gehäuse 23 abstrahlen können.

Vorzugsweise weist das Gehäuse 23 an seinen unteren Längsrändern 78, 78' Laschen 79 auf, die von den Rändern 78, 78' in Richtung auf das Basiselement 25 abstehen. Die Laschen 79 weisen Löcher auf, durch welche das mindestens eine Kühlelement 11, hier die acht als Schrauben ausgebildeten Kühlelemente 11 hindurchragen können. Die Löcher in den Laschen 79 fluchten in zusammengebautem Zustand der Trägereinrichtung 3, also in der Fixierungsstellung der Zusatzelemente 27 und 29 mit entsprechenden Aussparungen 66 in den Zusatzelementen 27 und 29. Sie fluchten außerdem mit den Löchern 13 in der Platine 5.

Werden also gemäß Figur 10 die Kühlelemente 11 durch die Laschen 79, die Aussparungen 66 in den Zusatzelementen 27 und 29 in die Löcher 13 der Platine 5 eingeführt, so werden die Zusatzelemente 27 und 29 in einer festen Relativposition zueinander und auch zum Basiselement 25 gehalten, sodass eine Relativ-Längsbewegung der Zusatzelemente 27 und 29 zueinander nicht möglich ist. Es ist also damit ausgeschlossen, dass die Zusatzelemente 27 und 29 aus Ihrer Fixierposition in die Halteposition gemäß Figur 7 oder die Fügeposition gemäß Figur 6 verlagert werden, in der die Platine 5 nicht mehr so sicher fixiert wird.

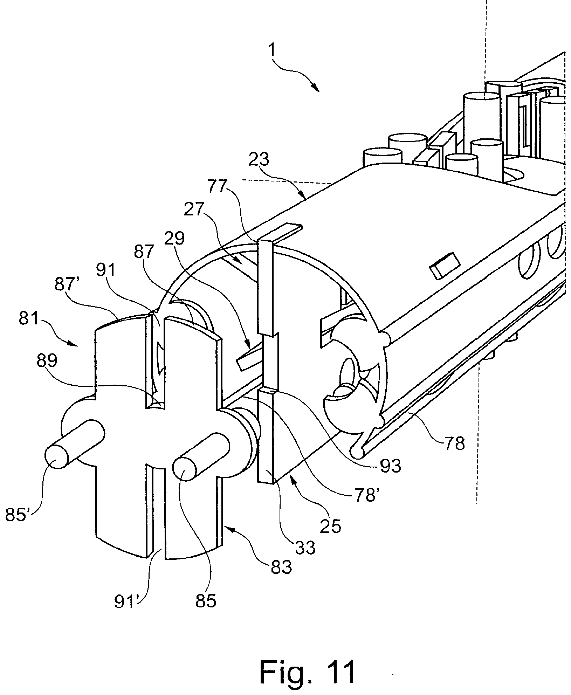

Figur 11 zeigt vergrößert das auch in Figur 10 ersichtliche Ende der Leuchteinheit 1 mit dem Basiselement 25, und den Zusatzelementen 27, 29 der Trägereinrichtung 3 und dem Gehäuse 23. In Explosionsdarstellung ist vor dem Gehäuse 23 ein Anschlusselement 81 mit einem vorzugsweise plattenförmigen Grundkörper 83 und mit mindestens einem hier als Kontaktstift ausgebildeten Kontaktelement. Das hier dargestellte Ausführungsbeispiel des Anschlusselements 81 weist zwei Kontaktelemente beziehungsweise Kontaktstifte 85 und 85' auf.

Der Grundkörper 83 weist zwei hier im Wesentlichen senkrecht stehende Seitenelemente 87 und 87' auf, die über einen Steg 89 miteinander verbunden sind. Oberhalb und Unterhalb des Stegs 89 sind Schlitze 91 und 91', in welche das Basiselement 25 eingreift. Dieses weist an seinem dem Betrachter zugewandten Ende 33 eine Aussparung 93 auf, die so ausgelegt und ausgebildet ist, dass sie den Steg 89 aufnimmt, sodass das Anschlusselement 81 an dem Ende 33 des Basiselements 25 aufsteckbar ist und sicher gehalten wird.

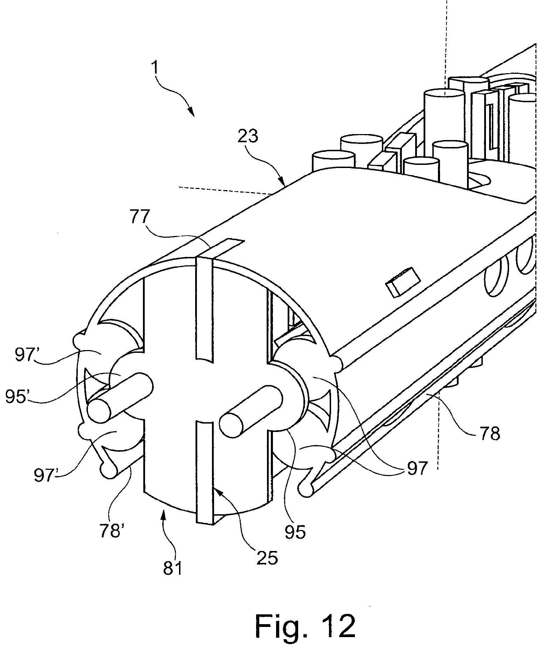

Figur 12 zeigt in perspektivischer Ansicht das in Figur 11 wiedergebebene Ende der Leuchteinheit 1 wiederum in vergrößerter Darstellung. Hier ist das Anschlusselement 81 auf das Ende 33 des Basiselements 25 aufgeschoben. Es befindet sich in seiner Montagestellung, in welcher das dem Betrachter zugewandten Ende des Gehäuses 23 weitgehend verschlossen ist.

Es zeigt sich hier, wie auch in Figur 11, dass zur Aufnahme des mindestens einen Kontaktelements, hier der beiden Kontaktstifte 85 und 85' von den Seitenelementen 87 und 87' ausgehende Vorsprünge 95 vorgesehen sind, an denen sich Abstandselemente 97 und 97' des Gehäuses 23 abstützen können. Dazu ist vorzugsweise die Außenkontur der Vorsprünge 95, 05' auf die Innenkontur der Abstände 97, 97' angepasst, sodass eine flächige Anlage der Abstandselemente an den Vorsprüngen gegeben ist. Von außen auf das Gehäuse 23 wirkenden Kräften werden also hier sicher abgefangen.

Auf der dem Betrachter abgewandten Seite des Gehäuses 23 kann eine an die Innenkontur des Gehäuses 23 angepasste Abdeckplatte vorgesehen werden, deren Grundkörper im Wesentlichen die Kontur des Grundkörpers 83 des Anschlusselements 81 aufweist. Die Abdeckplatte schützt das Innere der Leuchteinheit 1.

Bei einem abgewandelten Ausführungsbeispiel kann vorgesehen werden, dass auf der gegenüberliegenden Seite der Leuchteinheit 1 beziehungsweise an dem gegenüberliegenden Ende des Gehäuses 23 ein weiteres Anschlusselement vorgesehen ist, welches in den Figuren nicht wiedergegeben wird. Das Abschlusselement ist vorzugsweise identisch ausgebildet wie das in den Figuren 11 und 12 dargestellte.

An dem gegenüberliegenden Ende der Leuchteinheit 1 kann auch eine Abschlussplatte mit Aufnahmebuchsen vorgesehen werden, in welche Kontaktelemente, die vorzugsweise als Kontaktstifte ausgebildet sind, eingreifen. Es ist damit möglich, eine Anzahl von Leuchteinheiten 1 herzustellen, die auf einer Seite ein Anschlusselement 81, wie in den Figuren 11 und 12, dargestellt aufweisen und auf der anderen Seite eine Abschlussplatte mit zwei Buchsen. Die so ausgebildeten Leuchtelemente 1 können hintereinander angeordnet und miteinander elektrisch verbunden werden, indem die Kontaktstifte eines Leuchtelements in die Kontaktbuchsen eines anderen Leuchtelements eingesteckt werden und zwei Kontaktstifte mit einer Energieversorgung gekoppelt werden.

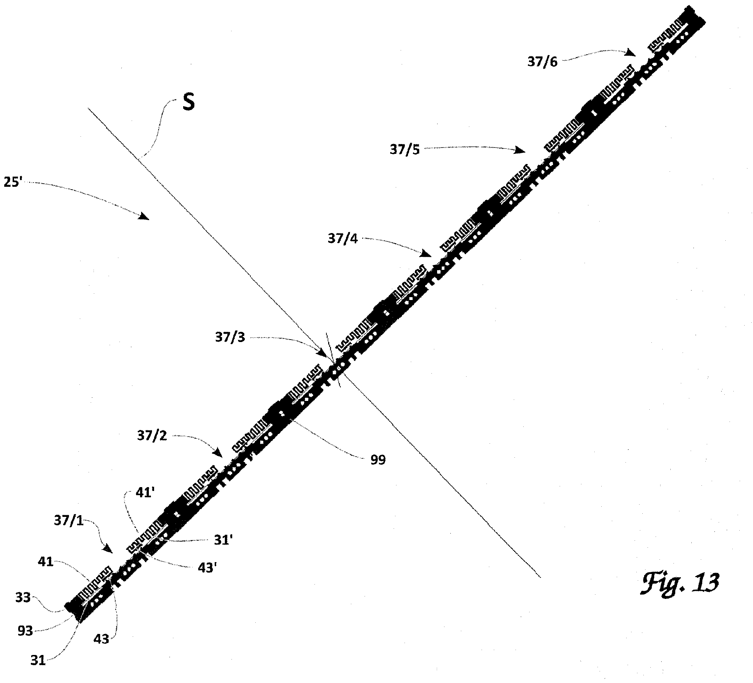

Figur 13 zeigt ein abgewandeltes Ausführungsbeispiel eines Basisteils 25, wie es in Figur 2 dargestellt ist. Gleiche Teile sind mit gleichen Bezugsziffern versehen, sodass auf die vorangegangene Beschreibung der Figuren verwiesen wird.

Figur 2 zeigt ein Basisteil 25 mit zwei gegenüberliegenden Enden 33 und 33' an denen Wandbereiche 39 und 39' vorgesehen sind, von denen jeweils ein Arm 41, 41' entspringt und zwar derart, dass zwischen der Enden der Arme eine Längsausnehmung 37 vorhanden ist.

Figur 13 zeigt, dass das Basiselement so ausgebildet werden kann, dass quasi mehrere Basiselemente 25, wie sie in Figur 2 dargestellt sind, an einem langgestreckten Grundkörper 99 ausgebildet werden. Bei dem in Figur 13 dargestellten Ausführungsbeispiel weist der Grundkörper quasi sechs aneinandergereihte Basiselemente auf, sodass sechs Längsausnehmungen 37/1 bis 37/6 ausgebildet werden, die jeweils von Armen 41, 41' begrenzt sind, wie sie anhand von Figur 2 erläutert wurden.

Ein derartiges Basiselement 25' weist also letztlich sechs Leuchtelemente auf und sechs Bereiche, in denen von zwei gegenüberliegenden Seiten des Basiselements 25' Zusatzelemente 27 und 29 einsteckbar ist, wie dies anhand des Basiselements 25 gemäß den Figuren 1 bis 10 erläutert wurde.

Ein derartig langgestrecktes Basiselement 25 kann einzelne aneinander angrenzende Gehäuse 23 aufweisen, wie sie oben beschrieben wurden, oder aber ein durchgehendes Gehäuse welches alle sechs Längsausnehmungen 37/1 bis 37/6 überspannt.

Die Außenkontur des Gehäuses 23 kann bei beiden Ausführungsbeispielen so ausgelegt sein, dass es gemeinsam mit den übrigen Teilen der Leuchteinheit 1 in ein Rohr, vorzugsweise in ein Glasrohr einführbar ist. Auf diese Weise kann mit Hilfe einer oder mehrerer Leuchteinheiten eine Leuchtstoffröhre ersetzt werden.

Während das in Figur 13 dargestellte Basiselement 25' zwei oder mehr Längsausnehmungen 37 aufweisen kann, kann die Länge des Basiselements 25' an verschiedene Einsatzfälle angepasst werden. Es können also Leuchteinheiten mit verschiedener Länge und unterschiedlich vielen Leuchtelementen realisiert werden, die dann Leuchtstoffröhren mit verschiedenen Ausmaßen ersetzen können.

Mit Hilfe der hier dargestellten Leuchteinheit 1 können also sehr variable Leuchten realisiert werden, insbesondere solche, die bestehende Leuchtstoffröhren ersetzen.

Die für die elektrische Versorgung des Leuchtelements 1 und der zugehörigen elektrischen/elektronischen Bauteile erforderlichen Leitungen können vorzugsweise in das Basiselement 25 integriert werden. Besonders bevorzugt wird vorgesehen, dass das Basiselement 25 aus für Platinen üblichem Material hergestellt werden und mit auf herkömmliche Weise hergestellten Leiterbahnen versehen sind, die einerseits die als Kontaktstifte 85, 85' ausgebildeten Kontaktelemente und andererseits die Kontaktierungsflächen 21, 21' über die Kontaktarme 43, 43' miteinander verbinden, sodass das Leuchtelement und zugehörigen Bauteile mit einer externen Stromversorgung verbindbar ist.

## Patentansprüche

1. Leuchteinheit (1) mit
- einer Trägereinrichtung (3),
- einer Platine (5), die mit der Trägereinrichtung (3) und mit einer Energieversorgung verbindbar ist,
- einem auf der Platine (5) positionierten Leuchtelement (7),
**dadurch gekennzeichnet, dass**
- die Trägereinrichtung (3) wenigstens ein Basiselement (25) und mindestens zwei Zusatzelemente (27,29) umfasst, wobei
- das Basiselement (25) und/oder die mindestens zwei Zusatzelemente (27,29), vorzugsweise plattenförmig ausgebildet sind,
- das Basiselement (25) und die mindestens zwei Zusatzelemente (27,29) zusammensteckbar sind,
- das Basiselement (25) Längsschlitze (31,31') aufweist, durch welche die mindestens zwei Zusatzelemente (27,29) seitlich in das Basiselement (25) einschiebbar sind,
- die mindestens zwei Zusatzelemente (27,29) Längsschlitze (55,57) aufweisen, sodass sie gegenüber dem Basiselement (25) und relativ zueinander in Längsrichtung verschiebbar sind,
- das Basiselement (25) und die mindestens zwei Zusatzelemente (27,29) mindestens eine Längsausnehmung (37,59) aufweisen und die ineinandergesteckten Elemente einen durch die Längsausnehmungen definierten Aufnahmebereich bilden,
- die Platine (5) in den Aufnahmebereich so einsetzbar ist, dass sie gegenüber dem Basiselement (25) lagefixiert ist,
- mindestens ein Zusatzelement (27,29) gegenüber dem Basiselement (25), gegenüber dem mindestens einen weiteren Zusatzelement und gegenüber der Platine (5) in Längsrichtung in eine Verriegelungsstellung verschiebbar ist, in welcher die Elemente untereinander und die Platine (5) an den Elementen gehalten werden.

2. Leuchteinheit (1) nach Anspruch 1, **dadurch gekennzeichnet, dass** die mindestens zwei Zusatzelemente (27,29) in zusammengebautem Zustand der Leuchteinheit (1) unter einem Winkel gegenüber dem Basiselement (25) angeordnet sind, wobei der Winkel vorzugsweise 45° beträgt.

3. Leuchteinheit (1) nach Anspruch 1, **dadurch gekennzeichnet, dass** die Zusatzelemente (27,29) identisch ausgebildet und in entgegengesetzter Längsorientierung in das Basiselement (25) einsetzbar sind.

4. Leuchteinheit (1) nach Anspruch 1, **gekennzeichnet durch** mindestens ein mit der Platine (5) gekoppeltes Kühlelement (11) einer Kühleinrichtung (9).

5. Leuchteinheit (1) nach Anspruch 4, **dadurch gekennzeichnet, dass** das mindestens eine Kühlelement (11) in zusammengebautem Zustand der Leuchteinheit (1) mit mindestens einem der Zusatzelemente (27,29) derart zusammenwirkt, dass das mindestens eine Zusatzelement - in Längsrichtung gesehen - lagefixiert ist.

6. Leuchteinheit (1) nach Anspruch 1, **dadurch gekennzeichnet, dass** die Trägereinrichtung (3), vorzugsweise das Basiselement (25) der Trägereinrichtung (3), einen elektrisch leitenden Bereich aufweist, über den die Platine (5) und somit das Leuchtelement (7) mit Energie versorgbar ist.

7. Leuchteinheit (1) nach Anspruch 6, **dadurch gekennzeichnet, dass** der leitende Bereich an mindestens einem Kontaktarm (43,43') vorgesehen ist.

8. Leuchteinheit (1) nach Anspruch 7, **dadurch gekennzeichnet, dass** der Kontaktarm (43,43') an einem Arm (41,41') vorgesehen ist.

9. Leuchteinheit (1) nach Anspruch 1, **gekennzeichnet durch** ein - vorzugsweise einen Ausschnitt (73') für das Leuchtelement (7) aufweisendes - Gehäuse (23).

10. Leuchteinheit (1) nach Anspruch 9, **dadurch gekennzeichnet, dass** das Gehäuse (23) Durchbrechungen (77) aufweist, in welche von mindestens einem der Zusatzelemente (27,29) ausgehende Vorsprünge zur Realisierung einer Lagefixierung eingreifen.

11. Leuchteinheit (1) nach Anspruch 1, **dadurch gekennzeichnet, dass** die Trägereinrichtung (3) eine Anzahl von Längsausnehmungen (37/1,37/2ff) mit einem Leuchtelement (7) versehenen Platinen (5) aufweist, die hintereinander - in Längsrichtung der Leuchteinheit (1) gesehen - angeordnet sind.

12. Leuchteinheit (1) nach einem der vorhergehenden Ansprüche, **gekennzeichnet durch** ein langgestrecktes Basiselement mit einer Anzahl von über die Länge des Basiselements verteilten Platinen (5) mit Leuchtelementen (7).

## Claims

1. A lighting unit (1) having
- a carrier device (3),
- a board (5) connectable to the carrier device (3) and to an energy supply,
- a lighting element (7) positioned on the board (5),
**characterised in that**
- the carrier device (3) comprises at least one base element (25) and at least two additional elements (27, 29), wherein
- the base element (25) and/or the at least two additional elements (27, 29) preferably have a plate-shaped configuration,
- the base element (25) and the at least two additional elements (27, 29) can be plugged into each other,
- the base element (25) has longitudinal slots (31,31') through which the at least two additional elements (27, 29) can be inserted laterally into the base element (25),
- the at least two additional elements (27, 29) have longitudinal slots (55, 57) such that they are displaceable in the longitudinal direction with respect to the base element (25) and relative to one another,
- the base element (25) and the at least two additional elements (27, 29) have at least one longitudinal recess (37, 59), and the elements that are plugged into each other form a receiving region defined by the longitudinal recesses,
- the board (5) can be inserted into the receiving region in such a way that it is fixed in place with respect to the base element (25),
- at least one additional element (27, 29) can be displaced in the longitudinal direction with respect to the base element (25), the at least one other additional element and the board (5) into a locking position in which the elements are held between themselves and the board (5) is held on the elements.

2. The lighting unit (1) according to claim 1, **characterised in that** the at least two additional elements (27, 29) are arranged at an angle with respect to the base element (25) in the assembled state of the lighting unit (1), wherein the angle preferably is 45°.

3. The lighting unit (1) according to claim 1, **characterised in that** the additional elements (27, 29) have an identical configuration and can be inserted into the base element (25) in opposing longitudinal orientation.

4. The lighting unit (1) according to claim 1, **characterised by** at least one cooling element (11) coupled to the board (5), the cooling element being associated with a cooling device (9).

5. The lighting unit (1) according to claim 4, **characterised in that** the at least one cooling element (11) cooperates with at least one of the additional elements (27, 29) in the assembled state of the lighting unit (1) in such a way that the at least one additional element is fixed in place, as viewed in the longitudinal direction.

6. The lighting unit (1) according to claim 1, **characterised in that** the carrier device (3), preferably the base element (25) of the carrier device (3), has an electrically conductive region through which the board (5) and thus the lighting element (7) can be supplied with energy.

7. The lighting unit (1) according to claim 6, **characterised in that** the conductive region is provided on at least one contacting arm (43, 43').

8. The lighting unit (1) according to claim 7, **characterised in that** the contacting arm (43, 43') is provided on an arm (41, 41').

9. The lighting unit (1) according to claim 1, **characterised by** a housing (23) that preferably has a cutout (73') for the lighting element (7).

10. The lighting unit (1) according to claim 9, **characterised in that** the housing (23) has breakouts (77) into which projections extending from at least one of the additional elements (27, 29) engage in order to implement a fixation in place.

11. The lighting unit (1) according to claim 1, **characterised in that** the carrier device (3) has a number of longitudinal recesses (37/1, 37/2ff) for boards (5) having a lighting element (7), the recesses being arranged one after the other when seen in the longitudinal direction of the lighting unit (1).

12. The lighting unit (1) according to any one of the preceding claims, **characterised by** an elongated base element having a number of boards (5) with lighting elements (7), the boards being distributed over the length of the base element.

## Revendications

1. Unité d'éclairage (1) avec
- un dispositif de support (3),
- une carte de circuit (5) qui peut être reliée avec le dispositif de support (3) et avec une alimentation en énergie,
- un élément d'éclairage (7) positionné sur la carte de circuit (5),
**caractérisée en ce que**
- le dispositif de support (3) comprend au moins un élément de base (25) et au moins deux éléments complémentaires (27, 29),
- l'élément de base (25) et/ou les au moins deux éléments complémentaires (27, 29) étant de préférence configurés sous forme de plaque,
- l'élément de base (25) et les au moins deux éléments complémentaires (27, 29) étant enfichables l'un dans l'autre,
- l'élément de base (25) ayant des fentes longitudinales (31,31') par lesquelles les au moins deux éléments complémentaires (27, 29) peuvent être insérés latéralement dans l'élément de base (25),
- les au moins deux éléments complémentaires (27, 29) ayant des fentes longitudinales (55, 57) de telle manière qu'ils sont déplaçables par rapport à l'élément de base (25) et l'un par rapport à l'autre dans la direction longitudinale,
- l'élément de base (25) et les au moins deux éléments complémentaires (27, 29) ayant au moins un évidement longitudinal (37, 59), et les éléments enfichés l'un dans l'autre formant une région de réception définie par les évidements longitudinaux,
- la carte de circuit (5) étant insérable dans la région de réception de telle manière qu'elle est fixée dans sa position par rapport à l'élément de base (25),
- au moins un élément complémentaire (27, 29) étant déplaçable dans la direction longitudinale par rapport à l'élément de base (25), par rapport à l'au moins un outre élément complémentaire et par rapport à la carte de circuit (5) vers une position de verrouillage, dans laquelle les éléments sont maintenus entre eux, et la carte de circuit (5) sur les éléments.

2. Unité d'éclairage (1) selon la revendication 1, **caractérisée en ce que** les au moins deux éléments complémentaires (27, 29) sont disposés, dans l'état assemblé de l'unité d'éclairage (1), sous un angle par rapport à l'élément de base (25), l'angle étant de préférence 45°.

3. Unité d'éclairage (1) selon la revendication 1, **caractérisée en ce que** les éléments complémentaires (27, 29) ont une configuration identique et sont insérables dans l'élément de base (25) dans une orientation longitudinale opposée.

4. Unité d'éclairage (1) selon la revendication 1, **caractérisée par** au moins un élément de refroidissement (11) couplé avec la carte de circuit (5), l'élément de refroidissement étant associé à un dispositif de refroidissement (9).

5. Unité d'éclairage (1) selon la revendication 4, **caractérisée en ce que** l'au moins un élément de refroidissement (11) coopère, dans l'état assemblé de l'unité d'éclairage (1), avec au moins un des éléments complémentaires (27, 29) de telle manière que l'au moins un élément complémentaire est fixé dans sa position, vu dans la direction longitudinale.

6. Unité d'éclairage (1) selon la revendication 1, **caractérisée en ce que** le dispositif de support (3), de préférence l'élément de base (25) du dispositif de support (3), présente une région électroconductrice par laquelle la carte de circuit (5) et ensuite l'élément d'éclairage (7) peut être alimenté en énergie.

7. Unité d'éclairage (1) selon la revendication 6, **caractérisée en ce que** la région conductrice est prévue sur au moins un bras de contact (43, 43').

8. Unité d'éclairage (1) selon la revendication 7, **caractérisée en ce que** le bras de contact (43, 43') est prévu sur un bras (41,41').

9. Unité d'éclairage (1) selon la revendication 1, **caractérisée par** un boîtier (23) qui de préférence présente une découpe (73') pour l'élément d'éclairage (7).

10. Unité d'éclairage (1) selon la revendication 9, **caractérisée en ce que** le boîtier (23) présente des perçages (77) dans lesquels des saillies s'étendant à partir d'au moins un des éléments complémentaires (27, 29) s'engagent pour réaliser une fixation en position.

11. Unité d'éclairage (1) selon la revendication 1, **caractérisée en ce que** le dispositif de support (3) présente un nombre des évidements longitudinaux (37/1, 37/2ff) pour des cartes de circuit (5) fournie avec un élément d'éclairage (7), les évidements étant disposés l'un après l'autre, vu dans la direction longitudinale de l'unité d'éclairage (1).

12. Unité d'éclairage (1) selon l'une quelconque des revendications précédentes, **caractérisée par** un élément de base élongé avec un nombre des cartes de circuit (5) avec des éléments d'éclairage (7), les cartes étant distribuées le long de la longueur de l'élément de base.
